# DEMANDE DE BREVET EUROPEEN

(11) **EP 3 038 149 A1**
(43) Date de publication de la demande: **29.06.2016**
(21) Numéro de dépôt: 15201708.3
(22) Date de dépôt: 21.12.2015
(51) Int. Cl.: H01L 21/822, H01L 21/768, H01L 27/06

(54) **PROCEDE DE REALISATION D'UN CIRCUIT INTEGRE EN TROIS DIMENSIONS**

(30) Priorité: 22.12.2014 FR 1463111
(71) Demandeur: Commissariat à l'Énergie Atomique et aux Énergies Alternatives, 75015 Paris (FR)
(72) Inventeur: DEPRAT, Fabien, 38000 GRENOBLE (FR); BATUDE, Perrine, 21000 DIJON (FR); MORAND, Yves, 38000 GRENOBLE (FR); NIEBOJEWSKI, Heimanu, 38000 GRENOBLE (FR); POSSEME, Nicolas, 38000 GRENOBLE (FR)
(74) Mandataire: Brevalex

(57) **Abrégé**

Procédé de réalisation d'un circuit intégré, comprenant au moins les étapes suivantes :
a) formation d'un premier élément (11) semi-conducteur ou conducteur, recouvert d'une première couche isolante (13) sur laquelle est disposé un deuxième élément (21) semi-conducteur ou conducteur, recouvert d'une deuxième couche isolante (23) ;
b) formation d'une ouverture traversant au moins la deuxième couche isolante, exposant une portion du deuxième élément et débouchant au moins en partie sur le deuxième élément ou à côté du deuxième élément ;
c) formation d'un espaceur (22) localisé au niveau du deuxième élément et comportant au moins un matériau diélectrique disposé au moins entre le deuxième élément et l'ouverture ;
d) prolongement de l'ouverture à travers la première couche isolante jusqu'à atteindre le premier élément ; et
e) remplissage de l'ouverture par au moins un matériau conducteur (37), de façon à former un contact.

L'étape c) de formation de l'espaceur (22) comporte au moins les étapes suivantes :
- gravure isotrope d'une partie du deuxième élément (21) incluant au moins ladite portion du deuxième élément (21), de façon à former une cavité disposée entre les première (13) et deuxième (23) couches isolantes ;
- dépôt d'au moins un matériau diélectrique au moins sur les parois de l'ouverture et dans la cavité ; et
- élimination du matériau diélectrique excepté dans la cavité.

## Description

### DOMAINE TECHNIQUE

La présente invention concerne un procédé de réalisation d'un circuit intégré en trois dimensions (3D), et plus particulièrement un procédé de formation de contacts dits 3D permettant de relier électriquement des éléments de niveaux non adjacents.

### ÉTAT DE LA TECHNIQUE ANTÉRIEURE

Les technologies basées sur l'empilement de puces ou de circuits sur plusieurs niveaux, couramment désignées par l'appellation « intégration 3D », permettent d'augmenter la densité d'intégration des composants et de réduire les délais dus aux interconnexions en réduisant leurs longueurs.

Dans certains cas, on veut relier électriquement des éléments de niveaux non adjacents, c'est-à-dire séparés par un ou plusieurs niveaux intermédiaires. Pour ne pas perturber le fonctionnement des dispositifs des niveaux intermédiaires traversés, les contacts reliant les éléments de niveaux non adjacents sont alors généralement formés à une certaine distance des zones d'accès à ces dispositifs des niveaux intermédiaires. Ceci permet d'éviter un court-circuit entre une zone d'accès d'un niveau intermédiaire et le contact. Néanmoins, il en résulte une réduction de la densité d'intégration.

Il se pose donc le problème de réaliser des contacts 3D permettant de relier électriquement des éléments de niveaux non adjacents tout en étant isolés électriquement des zones d'accès des niveaux intermédiaires traversés.

Il se pose également le problème d'augmenter la densité d'intégration de circuits comportant de tels contacts 3D.

### EXPOSÉ DE L'INVENTION

La présente invention vise notamment à résoudre ces problèmes.

La présente invention concerne un procédé de réalisation d'un contact 3D auto-aligné permettant de relier électriquement des éléments de niveaux non adjacents d'un circuit intégré 3D, tout en étant isolé électriquement d'une ou plusieurs zones d'accès d'un ou plusieurs dispositifs du ou des niveaux intermédiaires traversés.

D'une façon générale, pour réaliser un contact, une ouverture est formée à travers un ou plusieurs niveaux du circuit, par exemple par photolithographie et gravure, puis remplie de matériau conducteur.

Dans le cadre de la présente invention, on parle de contact auto-aligné par rapport à une ou plusieurs zones d'accès car sa réalisation implique la réalisation d'un espaceur diélectrique entre ce contact et la ou les zones d'accès, quelles que soient les variations technologiques liées à sa réalisation, par exemple quelles que soient les variations de position d'un outil de photolithographie utilisé (par exemple de type UV ou par faisceaux d'électrons). L'ouverture est formée de façon à exposer une ou plusieurs zones d'accès d'un ou plusieurs dispositifs du ou des niveaux intermédiaires traversés et déboucher au moins en partie sur, ou à côté de, cette ou ces zones d'accès. Un ou plusieurs espaceurs comportant un matériau diélectrique sont ensuite formés pour isoler électriquement le contact de cette (ou de ces) zone(s) d'accès.

La présente invention concerne un procédé de réalisation d'un circuit intégré, comprenant au moins les étapes suivantes :
a) formation d'un premier élément semi-conducteur ou conducteur, recouvert d'une première couche isolante sur laquelle est disposé un deuxième élément semi-conducteur ou conducteur, recouvert d'une deuxième couche isolante ;
b) formation d'une ouverture traversant au moins la deuxième couche isolante, exposant une portion du deuxième élément et débouchant au moins en partie sur le deuxième élément ou à côté du deuxième élément ;
c) formation d'un espaceur localisé au niveau du deuxième élément et comportant au moins un matériau diélectrique disposé au moins entre le deuxième élément et l'ouverture ;
d) prolongement de l'ouverture à travers la première couche isolante jusqu'à atteindre le premier élément ; et
e) remplissage de l'ouverture par au moins un matériau conducteur, de façon à former un contact.

Un avantage d'un procédé tel que celui décrit ci-dessus réside dans la réduction de la distance entre le contact et le deuxième élément, du fait que l'ouverture du contact est formée telle qu'elle expose une portion du deuxième élément et en débouchant sur le deuxième élément ou à côté du deuxième élément, le contact étant isolé du deuxième élément par l'espaceur. Il en résulte une augmentation de la densité d'intégration du circuit.

Selon un mode de réalisation, lors de l'étape b), l'ouverture peut être formée jusqu'à atteindre la première couche isolante.

Selon un autre mode de réalisation, les première et deuxième couches isolantes peuvent être de même nature, c'est-à-dire comportent un ou plusieurs matériaux diélectriques similaires, et, lors de l'étape b), l'ouverture peut traverser en partie la première couche isolante.

Selon l'invention, l'étape c) de formation de l'espaceur peut comporter au moins les étapes suivantes :
- gravure isotrope d'une partie du deuxième élément incluant au moins ladite portion du deuxième élément de façon à former une cavité disposée entre les première et deuxième couches isolantes ;
- dépôt, par exemple conforme, d'au moins un matériau diélectrique au moins sur les parois de l'ouverture et dans la cavité ; et
- élimination du matériau diélectrique excepté dans la cavité.

Le dépôt du matériau diélectrique sur les parois de l'ouverture et dans la cavité, qui correspond à un ajout d'un matériau supplémentaire par rapport aux autres matériaux déjà présents au niveau des parois de l'ouverture et dans la cavité, ne correspond pas à une oxydation qui n'est pas un ajout de matériau supplémentaire mais une transformation des caractéristiques d'un matériau déjà présent.

Un avantage d'un procédé tel que celui décrit ci-dessus réside dans le fait qu'il peut être utilisé pour former un contact de faible diamètre (ou largeur), par exemple de l'ordre de quelques nanomètres. Ceci est lié au fait que ledit espaceur n'est pas formé dans l'ouverture du contact mais est disposé entre les première et deuxième couches isolantes, à côté de l'ouverture.

Selon une variante de réalisation, une dimension de la cavité sensiblement perpendiculaire à l'axe principal de l'ouverture peut être telle qu'une partie de la cavité ne soit pas remplie de matériau diélectrique après le dépôt du matériau diélectrique. Ainsi, la partie de la cavité qui n'est pas remplie de matériau diélectrique et l'espaceur peuvent former ensemble une zone d'isolation entre le deuxième élément et le contact.

Par dimension de la cavité sensiblement perpendiculaire à l'axe principal de l'ouverture, on entend une dimension de la cavité sensiblement parallèle à la surface supérieure de la première couche isolante.

Un avantage d'une telle variante réside dans le fait que l'isolation électrique entre le contact et le deuxième élément est améliorée.

Selon un mode de réalisation, lors de l'étape b), l'ouverture peut être formée de façon à déboucher en partie seulement sur le deuxième élément.

Selon un mode de réalisation, lors de l'étape b), l'ouverture peut être formée de façon à déboucher en partie seulement sur le deuxième élément ou à côté du deuxième élément, et l'espaceur peut être formé par oxydation d'au moins une partie de ladite portion du deuxième élément qui a été exposée par la formation de l'ouverture.

Un avantage d'un procédé tel que celui décrit ci-dessus réside dans son nombre réduit d'étapes de réalisation car l'espaceur est alors formé lors d'une étape unique d'oxydation localisée d'au moins une partie de la portion du deuxième élément qui a été exposée lors de la formation de l'ouverture.

Selon un mode de réalisation, lors de l'étape e) de remplissage de l'ouverture, une couche barrière électriquement conductrice peut être préalablement formée dans l'ouverture avant la formation du matériau conducteur. La couche barrière permet notamment d'éviter la diffusion du matériau conducteur vers les première et deuxième couches isolantes et vers ledit espaceur, ainsi que d'améliorer l'accroche du matériau conducteur déposé dans l'ouverture.

Selon un mode de réalisation, le premier élément peut être une zone active d'au moins un premier transistor ou une première ligne métallique, et/ou le deuxième élément peut être une zone active d'au moins un deuxième transistor ou une deuxième ligne métallique.

Selon un mode de réalisation, lors de l'étape a), au moins un élément intermédiaire semi-conducteur ou conducteur recouvert d'une couche isolante intermédiaire peut être disposé entre la première couche isolante et le deuxième élément. Dans ce cas, le procédé décrit ci-dessus peut comprendre en outre, entre les étapes c) et d), les étapes suivantes réalisées pour le ou chaque élément intermédiaire :
- prolongement de l'ouverture à travers la couche isolante intermédiaire recouvrant ledit élément intermédiaire, tel que l'ouverture expose une portion dudit élément intermédiaire et débouche au moins en partie sur ledit élément intermédiaire ou à côté dudit élément intermédiaire ; et
- formation d'un espaceur intermédiaire localisé au niveau dudit élément intermédiaire et comportant au moins un matériau diélectrique disposé au moins entre ledit élément intermédiaire et l'ouverture.

### BRÈVE DESCRIPTION DES DESSINS

D'autres caractéristiques et avantages de l'invention ressortiront plus clairement à la lecture de la description suivante et en référence aux dessins annexés, donnés à titre uniquement illustratif et nullement limitatif.
Les figures 1A à 1G sont des vues en coupe illustrant de façon schématique des étapes successives d'un exemple de procédé de réalisation d'un contact auto-aligné selon l'invention.
Les figures 2A à 2D sont des vues en coupe illustrant de façon schématique des étapes successives d'une variante du procédé des figures 1A-1G.
Les figures 3A à 3E sont des vues en coupe illustrant de façon schématique des étapes successives d'un autre exemple de procédé de réalisation d'un contact auto-aligné selon l'invention.
Les figures 3F à 3I sont des vues en coupe illustrant de façon schématique des étapes successives d'un autre exemple de procédé de réalisation d'un contact auto-aligné selon l'invention.
Les figures 4A à 4D sont des vues en coupe illustrant de façon schématique des étapes successives d'une autre variante du procédé des figures 1A-1G.
La figure 5 est une vue en coupe représentant de façon schématique un exemple de structure obtenue par un procédé selon l'invention.
La figure 6 est une vue en coupe représentant de façon schématique un autre exemple de structure obtenue par un procédé selon l'invention.
La figure 7 est une vue en coupe représentant de façon schématique un autre exemple de structure obtenue par un procédé selon l'invention.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

Il est décrit ci-dessous un procédé de réalisation d'un contact 3D auto-aligné permettant de relier électriquement des éléments de niveaux non adjacents d'un circuit intégré, tout en étant isolé électriquement des zones d'accès à des dispositifs des niveaux intermédiaires traversés.

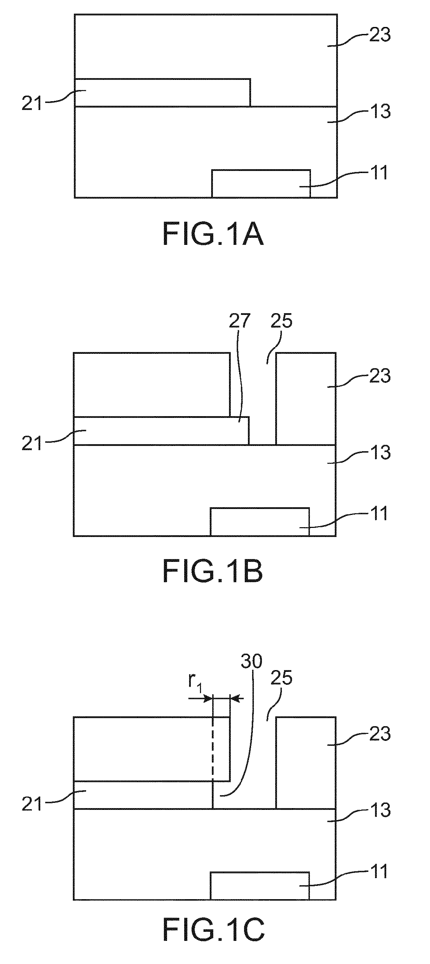

Les figures 1A à 1G sont des vues en coupe illustrant de façon schématique des étapes successives d'un exemple de procédé de réalisation d'un contact 3D auto-aligné.

La figure 1A représente deux niveaux adjacents d'un circuit intégré 3D. Le premier niveau comprend un premier élément 11, comportant au moins un matériau semi-conducteur ou au moins un matériau conducteur, recouvert d'une première couche isolante 13 comportant au moins un matériau diélectrique. Le deuxième niveau, disposé sur le premier niveau, comprend un deuxième élément 21, comportant au moins un matériau semi-conducteur ou au moins un matériau conducteur, recouvert d'une deuxième couche isolante 23 comportant au moins un matériau diélectrique.

Le deuxième niveau est par exemple formé par report sur la première couche isolante 13 ou par croissance par épitaxie, ou par dépôt et recristallisation laser. Les premier et deuxième niveaux sont par exemple formés sur un substrat (non représenté), d'autres niveaux pouvant être interposés entre le substrat et le premier niveau.

Le premier élément 11 est par exemple formé d'une zone d'accès à un ou plusieurs dispositifs, par exemple un ou plusieurs premiers transistors, ou d'une première ligne métallique. Le deuxième élément 21 est par exemple formé d'une zone d'accès à un ou plusieurs dispositifs, par exemple un ou plusieurs deuxièmes transistors, ou d'une deuxième ligne métallique.

A titre d'exemples d'ordres de grandeur de dimensions, l'épaisseur (dimension sensiblement perpendiculaire à l'interface entre les couches isolantes 13 et 23) du premier élément 11 peut être comprise entre environ 4 nm et 150 nm, par exemple de l'ordre de 70 nm, et l'épaisseur de la première couche isolante 13 peut être comprise entre environ 50 nm et 300 nm, par exemple de l'ordre de 120 nm. L'épaisseur du deuxième élément 21 peut être comprise entre environ 4 nm et 150 nm, par exemple de l'ordre de 6 nm, et l'épaisseur de la deuxième couche isolante 23 peut être comprise entre environ 100 nm et 300 nm, par exemple de l'ordre de 150 nm.

Un troisième niveau comportant au moins un troisième élément est destiné à être disposé sur le deuxième niveau. Il est décrit ci-dessous en relation avec les figures 1B-1G des étapes successives de formation d'un contact destiné à relier électriquement le premier élément 11 du premier niveau à un troisième élément du troisième niveau, le contact étant isolé électriquement du deuxième élément 21 du deuxième niveau intermédiaire.

La figure 1B illustre la formation d'une ouverture 25 traversant la deuxième couche isolante 23 et débouchant au moins en partie sur le deuxième élément 21. L'ouverture 25 est par exemple formée par photolithographie puis gravure.

Comme cela est illustré, l'ouverture 25 débouche en partie sur le deuxième élément 21. Selon une alternative, l'ouverture 25 peut déboucher en totalité sur le deuxième élément 21.

Dans cet exemple de réalisation, lors de cette étape, l'ouverture 25 est formée jusqu'à atteindre la première couche isolante 13.

Le procédé de gravure est choisi de façon à graver de façon sélective le matériau de la deuxième couche isolante 23 par rapport au matériau du deuxième élément 21 et par rapport au matériau de la première couche isolante 13.

Par gravure sélective d'un premier matériau par rapport à un second matériau, on entend que la vitesse de gravure du premier matériau est nettement supérieure à celle du second matériau, par exemple environ 3 fois supérieure à celle du second matériau.

Une fois l'ouverture 25 formée, une portion 27 du deuxième élément 21 est exposée dans l'ouverture 25.

La figure 1C illustre la gravure isotrope du deuxième élément 21, à partir de la portion exposée 27 du deuxième élément 21. La gravure est réalisée de façon à éliminer, en plus de la portion exposée 27 du deuxième élément 21, une partie du deuxième élément 21 disposée entre la première couche isolante 13 et la deuxième couche isolante 23.

On obtient ainsi une cavité 30 entre la première couche isolante 13 et la deuxième couche isolante 23.

La profondeur r₁ de la cavité 30 est par exemple comprise entre quelques angströms et quelques dizaines de nanomètres.

Une telle gravure correspond par exemple à une gravure humide de type TMAH.

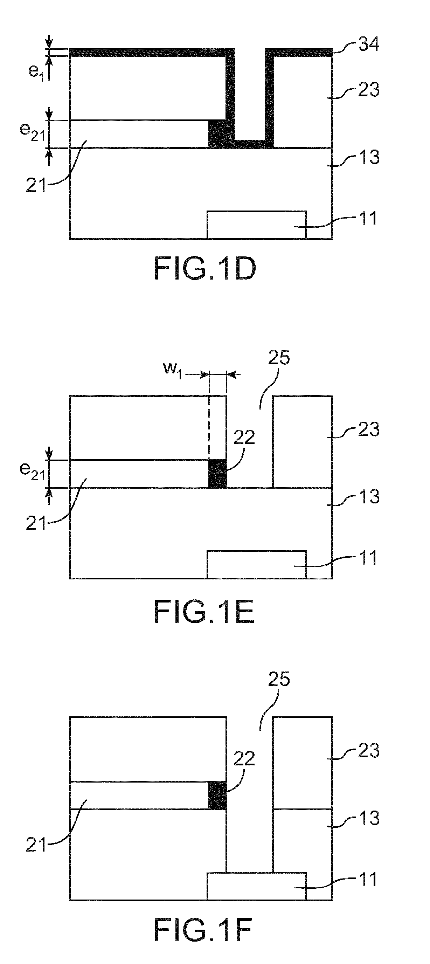

La figure 1D illustre le dépôt, correspondant ici à un dépôt conforme par exemple de type ALD (dépôt de couche atomique), d'un matériau diélectrique 34, par exemple du SiN, sur la deuxième couche isolante 23, sur les parois et au fond de l'ouverture 25, ainsi que dans la cavité 30. L'épaisseur de la couche du matériau diélectrique 34 est par exemple comprise entre environ 10 nm et 20 nm, par exemple égale à environ 13 nm.

La profondeur r₁ de la cavité 30, l'épaisseur e₂₁ du deuxième élément 21 et l'épaisseur e₁ du matériau diélectrique 34 sont par exemple choisies de sorte que le matériau diélectrique 34 remplisse entièrement la cavité 30. Eventuellement, le matériau diélectrique 34 peut recouvrir les parois et le fond de la cavité 30 sans remplir entièrement la cavité 30.

La figure 1E illustre l'élimination du matériau diélectrique 34, excepté dans la cavité 30. L'élimination du matériau diélectrique 34 est par exemple réalisée par gravure humide (par exemple par une première gravure HF mise en oeuvre pendant quelques secondes pour retirer l'oxyde natif puis par une deuxième gravure humide de type H₃PO₄ pour retirer le reste du matériau diélectrique 34 sauf dans la cavité 30).

Une portion restante de la couche de matériau diélectrique 34 forme donc un espaceur 22 disposé entre le deuxième élément 21 et l'ouverture 25. La largeur W₁ de l'espaceur 22 correspond par exemple à la profondeur r₁ de la cavité 30 formée lors de l'étape illustrée en figure 1C. La largeur W₁ de l'espaceur 22 est par exemple comprise entre quelques angströms et quelques dizaines de nanomètres.

La figure 1F illustre le prolongement de l'ouverture 25 à travers la première couche isolante 13, jusqu'à atteindre le premier élément 11, par exemple par gravure. Le procédé de gravure est choisi de façon à graver de façon sélective le matériau de la première couche isolante 13 par rapport au matériau diélectrique de l'espaceur 22 et par rapport au matériau diélectrique de la deuxième couche isolante 23.

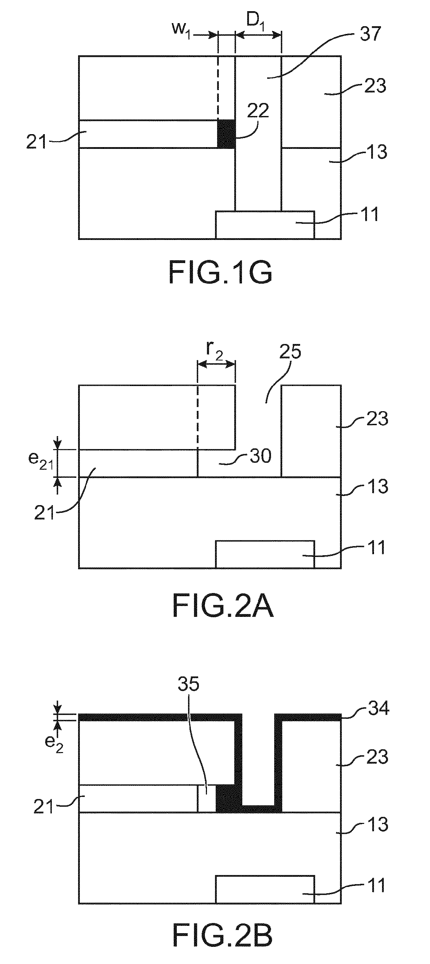

La figure 1G illustre le remplissage de l'ouverture 25 par au moins un matériau conducteur 37. Eventuellement, on forme préalablement une couche barrière, qui est ici électriquement conductrice, disposée au moins sur les parois de l'ouverture. Cette couche barrière est destinée à éviter la diffusion du matériau conducteur 37 vers les couches isolantes 13, 23 et vers l'espaceur 22 et/ou améliorer l'accroche du matériau conducteur 37. Ainsi, le remplissage de l'ouverture 25 est par exemple réalisé par le dépôt d'une couche barrière de type bicouche Ti/TiN, puis le dépôt d'une couche de croissance en tungstène par dépôt ALD, puis un dépôt CVD de tungstène à partir de B₂H₆ et de WF₆.

On a ainsi formé un contact 37 destiné à relier électriquement le premier élément 11 à un troisième élément d'un troisième niveau destiné à être formé sur le deuxième niveau comportant le deuxième élément 21. Le contact 37 est isolé électriquement du deuxième élément 21 du deuxième niveau par l'espaceur 22.

Un avantage d'un procédé tel que celui décrit en relation avec les figures 1A-1G réside dans la réduction de la distance entre le contact 37 et le deuxième élément 21, du fait que l'ouverture 25 est réalisée initialement au moins en partie en regard du deuxième élément 21 et que le contact 37 est isolé du deuxième élément 21 par l'espaceur 22 localisé judicieusement entre le deuxième élément 21 et le contact 37, au niveau du deuxième élément 21. Il en résulte une augmentation de la densité d'intégration.

Un autre avantage d'un procédé tel que celui décrit en relation avec les figures 1A-1G réside dans le fait qu'il peut être utilisé pour former un contact de faible diamètre (ou largeur) D₁, par exemple de l'ordre de quelques nanomètres. Ceci est lié au fait que l'espaceur 22 n'est pas formé dans l'ouverture 25 du contact mais est disposé entre les couches isolantes 13 et 23, à côté de l'ouverture 25.

Les figures 2A à 2D sont des vues en coupe illustrant de façon schématique des étapes successives d'une variante du procédé des figures 1A-1G.

On procède d'abord, comme cela a été décrit précédemment en relation avec la figure 1B, à la formation d'une ouverture 25 sur le deuxième élément 21.

La figure 2A illustre la gravure isotrope de la zone accès 21, à partir de la portion 27 du deuxième élément 21 qui a été exposée lors de la formation de l'ouverture 25. En plus de la portion exposée 27 du deuxième élément 21, une partie du deuxième élément 21 disposée entre la première couche isolante 13 et la deuxième couche isolante 23 et juxtaposée à la portion 27 est gravée de façon à former la cavité 30 entre la première couche isolante 13 et la deuxième couche isolante 23.

Selon cette variante, la profondeur r₂ de la cavité 30 est élevée, par exemple comprise entre environ 10 nm et 40 nm, par exemple de l'ordre de 20 nm. L'épaisseur e₂₁ du deuxième élément 21 est faible, par exemple comprise entre quelques nanomètres et quelques dizaines de nanomètres, par exemple de l'ordre de 6 nm.

La figure 2B illustre le dépôt du matériau diélectrique 34 sur la deuxième couche isolante 23, sur les parois et au fond de l'ouverture 25, ainsi que dans la cavité 30. Ce dépôt est tel que le matériau diélectrique 34 remplit seulement partiellement la cavité 30.

Après le dépôt du matériau diélectrique 34, une partie 35 de la cavité 30 n'est pas remplie de matériau diélectrique 34. La partie restante 35 de la cavité 30, disposée entre le deuxième élément 21 et le matériau diélectrique 34, est par exemple remplie par de l'air ambiant qui était présent dans l'équipement de dépôt lors du dépôt du matériau diélectrique 34.

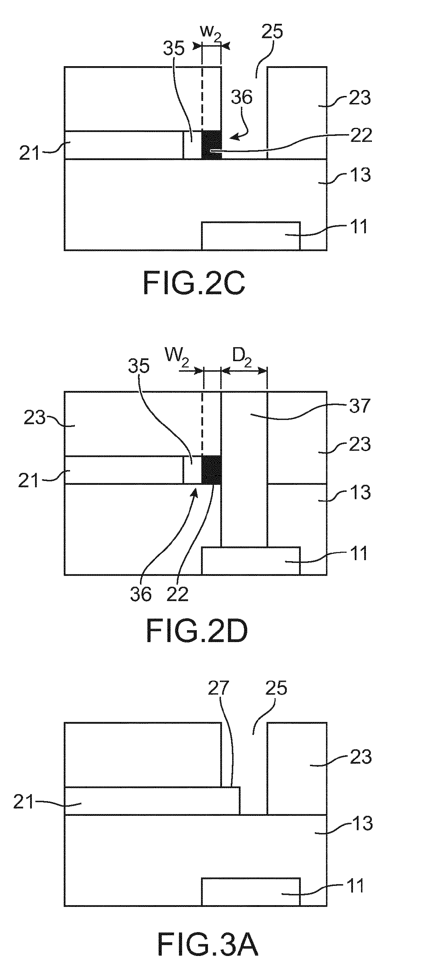

La figure 2C illustre l'élimination du matériau diélectrique 34, excepté dans la cavité 30. L'élimination du matériau diélectrique 34 est par exemple réalisée par gravure.

On a ainsi formé une zone d'isolation 36, entre le deuxième élément 21 et le contact en cours de formation, c'est-à-dire entre le deuxième élément 21 et l'ouverture 25. La zone d'isolation 36 est formée de la portion restante du matériau diélectrique 34, c'est-à-dire l'espaceur 22, et de la partie 35 de la cavité 30 qui est remplie d'air et qui forme donc également un élément diélectrique disposé entre l'ouverture 25 et le deuxième élément 21.

La largeur W₂ de l'espaceur 22 est par exemple comprise entre quelques angströms et quelques dizaines de nanomètres.

La figure 2D illustre le prolongement de l'ouverture 25 jusqu'à atteindre le premier élément 11 et le remplissage de l'ouverture 25 par le matériau conducteur 37 (et éventuellement par le dépôt préalable d'une couche barrière électriquement conductrice). Ces étapes correspondent à celles décrites en relation avec les figures 1F-1G et ne sont pas décrites à nouveau ci-après.

On a ainsi formé le contact 37 destiné à relier électriquement le premier élément 11 à un troisième élément d'un troisième niveau destiné à être formé sur le deuxième niveau comportant le deuxième élément 21. Le contact 37 est isolé électriquement du deuxième élément 21 du deuxième niveau par la zone d'isolation 36.

Un avantage d'un procédé tel que celui décrit en relation avec les figures 2A-2D réside dans le fait qu'il peut être utilisé pour former un contact de faible diamètre (ou largeur) D₂, par exemple de l'ordre de quelques nanomètres. Ceci est lié au fait que la zone d'isolation 36 n'est pas formée dans l'ouverture 25 du contact mais est disposée entre les couches isolantes 13 et 23, à côté de l'ouverture 25.

Un avantage de la variante décrite en relation avec les figures 2A-2D par rapport à un procédé tel que celui illustré en figures 1A-1G réside dans le fait que, pour un espaceur 22 de même largeur et de même nature, l'isolation électrique entre le contact et le deuxième élément 21 est améliorée grâce à la cavité 35.

Les figures 3A à 3D sont des vues en coupe illustrant de façon schématique des étapes successives d'un autre exemple de procédé de réalisation d'un contact 3D auto-aligné.

La figure 3A correspond à l'étape illustrée en figure 1B du procédé décrit en relation avec les figures 1A-1G et n'est pas décrite à nouveau ci-après. Une ouverture 25 est formée sur le deuxième élément 21.

Selon cet exemple de réalisation, l'ouverture 25 est formée de façon à déboucher en partie seulement sur le deuxième élément 21.

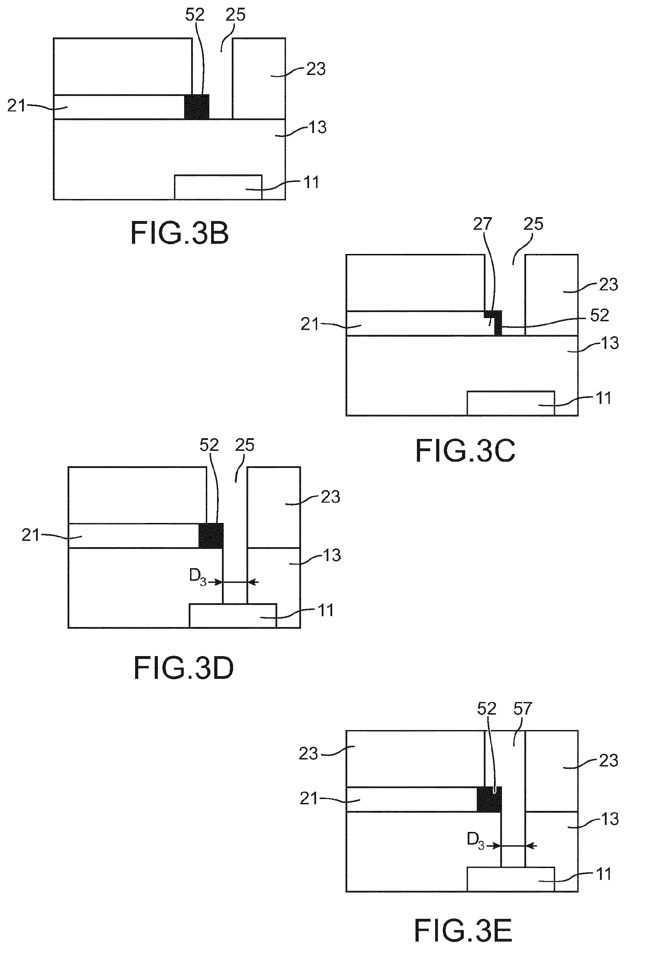

La figure 3B illustre l'oxydation localisée de la portion 27 du deuxième élément 21 qui a été exposée lors de la formation de l'ouverture 25.

Selon cet exemple de réalisation, le deuxième élément 21 est en un matériau qui s'oxyde, par exemple en silicium.

L'oxydation de la portion exposée 27 du deuxième élément 21 peut être réalisée par implantation dite tiltée. Par implantation tiltée, on entend l'implantation d'éléments par une face d'un substrat selon un certain angle par rapport à une direction perpendiculaire à cette face du substrat. Dans le cas où le deuxième élément 21 est en silicium, l'oxydation de la portion exposée 27 du deuxième élément 21 est par exemple réalisée par implantation d'oxygène. Avec une telle implantation, une partie du deuxième élément 21 qui n'est pas exposée dans l'ouverture 25 mais qui est juxtaposée à la portion 27 et qui se trouve entre les couches isolantes 13 et 23 peut également être oxydée. Sur la figure 3B, on voit qu'une première partie de l'espaceur 52 formé par cette oxydation par implantation est recouverte par la couche isolante 23, et qu'une deuxième partie de l'espaceur 52 correspond à la portion 27 qui est oxydée. En variante, il est toutefois possible que l'espaceur 52 ne soit formé que par la portion 27 oxydée. Selon une variante, l'oxydation de la portion exposée 27 du deuxième élément 21 peut correspondre à une oxydation de surface, et être réalisée en utilisant un plasma, par exemple par une méthode couramment désignée dans la technique par l'acronyme d'origine anglo-saxonne PLAD (« plasma doping »). Cette oxydation de surface peut également être réalisée dans une chambre à couplage capacitive ou inductive. Le résultat d'une telle oxydation de surface est représenté sur la figure 3C, sur laquelle on voit que l'oxyde est formé en surface de la portion 27.

On a ainsi formé un espaceur 52 comportant un matériau diélectrique entre le deuxième élément 21 et le contact en cours de formation. Selon cet exemple de réalisation, l'espaceur 52 n'est pas disposé entre les couches isolantes 13 et 23, mais est disposé dans l'ouverture 25.

La figure 3D illustre le prolongement de l'ouverture 25 à travers la première couche isolante 13, jusqu'à atteindre le premier élément 11, par exemple par gravure. Le procédé de gravure est choisi de façon à graver de façon sélective le matériau de la première couche isolante 13 par rapport au matériau diélectrique de l'espaceur 52 et par rapport au matériau diélectrique de la deuxième couche isolante 23.

Du fait de la présence de l'espaceur 52 dans l'ouverture 25, l'ouverture 25 présente un diamètre (ou une largeur) plus élevé dans la partie où elle traverse la deuxième couche isolante 23 que dans la partie où elle traverse la première couche isolante 13. On appelle D₃ le diamètre (ou la largeur) de l'ouverture dans la partie où elle traverse la première couche isolante 13. On prévoira de former une ouverture 25 suffisamment large lors de l'étape illustrée en figure 3A pour que le diamètre D₃ du contact soit suffisant en fonction de l'application visée.

La figure 3E illustre le remplissage de l'ouverture 25 par au moins un matériau conducteur 57. Eventuellement, on forme préalablement une couche de barrière, ici électriquement conductrice et disposée au moins sur les parois de l'ouverture. Cette couche de barrière est destinée à éviter la diffusion du matériau conducteur 57 vers les couches isolantes 13, 23 et vers l'espaceur 52 et/ou favoriser l'accroche du matériau conducteur 57.

On a ainsi formé un contact 57 destiné à relier électriquement le premier élément 11 à un troisième élément d'un troisième niveau destiné à être formé sur le deuxième niveau comportant le deuxième élément 21. Le contact 57 est isolé électriquement du deuxième élément 21 du deuxième niveau par l'espaceur 52.

Un avantage d'un procédé tel que celui décrit en relation avec les figures 3A-3E réside dans la réduction de la distance entre le contact 57 et le deuxième élément 21, du fait que l'ouverture 25 est réalisée initialement au moins en partie en regard du deuxième élément 21 et que le contact 57 est isolé du deuxième élément 21 par l'espaceur 52. Il en résulte une augmentation de la densité d'intégration.

Un autre avantage d'un procédé tel que celui décrit en relation avec les figures 3A-3E réside dans son nombre réduit d'étapes de réalisation. L'espaceur 52 est formé lors d'une étape unique d'oxydation localisée au moins de la partie exposée 27 du deuxième élément 21.

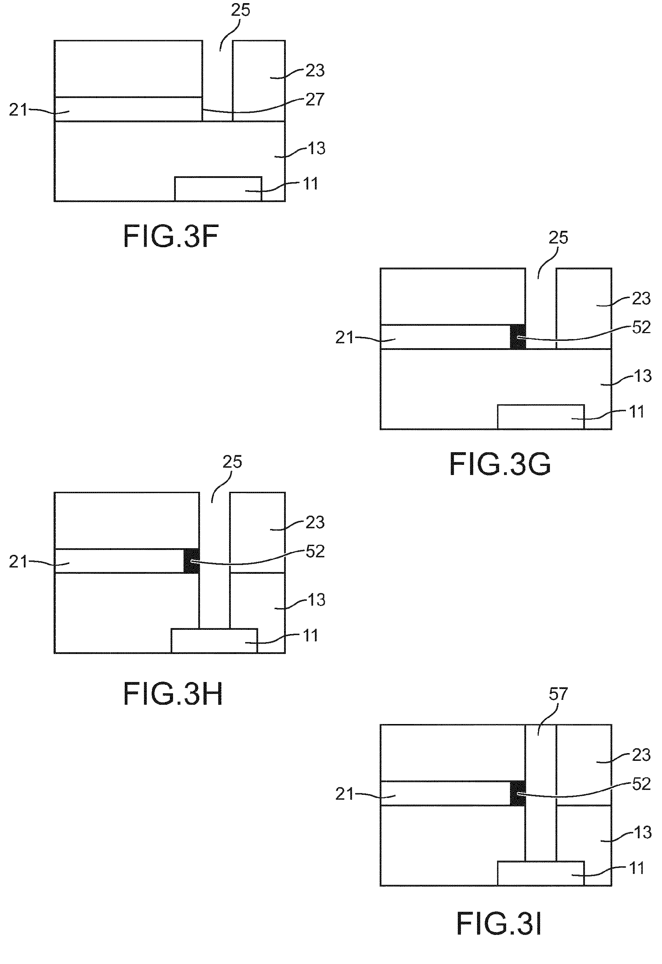

Les figures 3F à 3I sont des vues en coupe illustrant de façon schématique des étapes successives d'une variante du procédé de réalisation d'un contact 3D auto-aligné précédemment décrit en liaison avec les figures 3A-3E.

Comme représenté sur la figure 3F, l'ouverture 25 est ici réalisée de façon à déboucher entièrement sur la couche isolante 13, et telle que l'ouverture 25 débouche à côté du deuxième élément 21 en affleurant le deuxième élément 21. Une partie de la paroi latérale de l'ouverture 25 est formée par le deuxième élément 21, correspondant à la portion 27 du deuxième élément 21 qui est exposée.

La portion 27 du deuxième élément 21 accessible depuis l'ouverture 25 est ensuite oxydée, par exemple via une oxydation réalisée dans une chambre à couplage capacitive ou inductive, formant ainsi l'espaceur 52 (figure 3G).

On a ainsi formé un espaceur 52 comportant un matériau diélectrique entre le deuxième élément 21 et le contact en cours de formation. Selon cette variante, l'espaceur 52 est disposé entre les couches isolantes 13 et 23.

La figure 3H illustre le prolongement de l'ouverture 25 à travers la première couche isolante 13, jusqu'à atteindre le premier élément 11, par exemple par gravure. Le procédé de gravure est choisi de façon à graver de façon sélective le matériau de la première couche isolante 13 par rapport au matériau diélectrique de l'espaceur 52 et par rapport au matériau diélectrique de la deuxième couche isolante 23.

Du fait de la présence de l'espaceur 52 entre les couches isolantes 13 et 23, l'ouverture 25 présente un diamètre (ou une largeur) sensiblement similaire dans les deux couches isolantes 13 et 23.

La figure 3I illustre le remplissage de l'ouverture 25 par au moins un matériau conducteur 57. Eventuellement, on forme préalablement une couche barrière, qui est ici électriquement conductrice, disposée au moins sur les parois de l'ouverture. Cette couche de barrière est destinée à éviter la diffusion du matériau conducteur 57 vers les couches isolantes 13, 23 et vers l'espaceur 52 et/ou favoriser l'accroche du matériau conducteur 57.

On a ainsi formé un contact 57 destiné à relier électriquement le premier élément 11 à un troisième élément d'un troisième niveau destiné à être formé sur le deuxième niveau comportant le deuxième élément 21. Le contact 57 est isolé électriquement du deuxième élément 21 du deuxième niveau par l'espaceur 52.

Les avantages de ce procédé sont similaires à ceux précédemment décrits pour le procédé décrit pour les figures 3A-3E.

Différents exemples de réalisation et variantes d'un procédé de réalisation d'un contact 3D auto-aligné ont été décrits ci-dessus dans le cas où les couches isolantes 13 et 23 sont de natures différentes. Il est décrit ci-dessous une variante pouvant être utilisée dans le cas où les couches isolantes 13 et 23 sont de même nature.

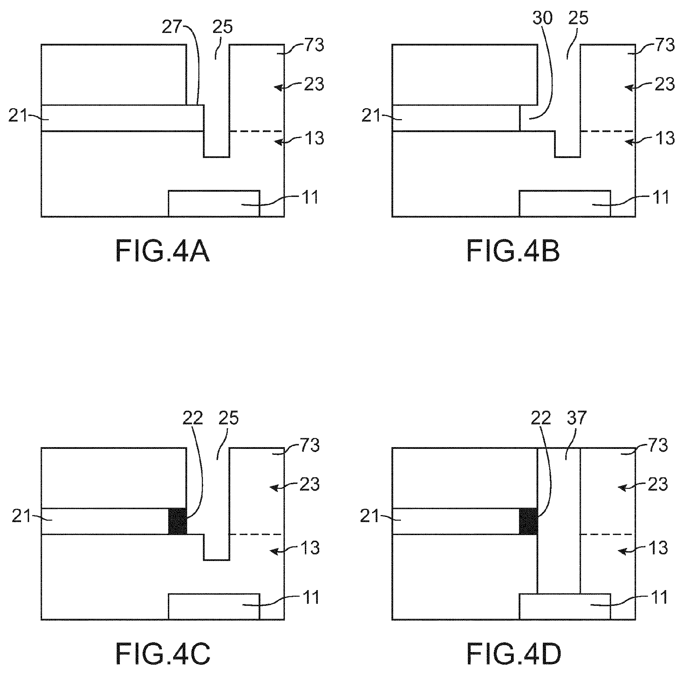

Les figures 4A à 4D sont des vues en coupe illustrant de façon schématique des étapes successives d'une variante d'un procédé tel que celui décrit en relation avec les figures 1A-1G, dans le cas où les couches isolantes 13 et 23 sont formées du même matériau diélectrique 73.

La figure 4A illustre la formation d'une ouverture 25 auto-alignée sur le deuxième élément 21. L'ouverture 25 traverse le matériau diélectrique 73 et débouche au moins en partie sur le deuxième élément 21.

Pour réaliser cette ouverture 25, un masque dur, comportant par exemple du TiN et ayant une épaisseur comprise entre environ 15 nm et 50 (par exemple égale à 35 nm), est formé sur la couche isolante 23. L'épaisseur de ce masque dur est choisie telle qu'elle soit supérieure à l'épaisseur de matériau diélectrique qui sera déposée ultérieurement dans l'ouverture 25 pour former l'espaceur 22. Un masque dur de TiN a pour avantage de présenter une forte résistance au plasma de gravure du SiO₂ qui correspond au matériau diélectrique 73.

Une couche antireflet est ensuite déposée sur le masque dur.

La photolithographie destinée à réaliser l'ouverture 25 est ensuite réalisée dans la couche antireflet, puis le motif de photolithographie est transféré dans le masque dur. La couche antireflet et le masque dur sont ensuite gravés conformément au motif photolithographié, par exemple par plasma. Les radicaux pouvant être utilisés lors de la gravure plasma du TiN sont par exemple : F, CFx, H, CI et BClx.

Le matériau diélectrique 73 est ensuite gravé partiellement.

Selon cette variante, l'ouverture 25 est formée par gravure partielle du matériau diélectrique 73. L'ouverture 25 traverse la deuxième couche isolante 23 et une partie de la première couche isolante 13.

Une fois l'ouverture 25 formée, une portion 27 du deuxième élément 21 est exposée. Cette portion 27 est gravée par exemple dans une chambre à couplage capacitif en chimie fluorocarbonée de type C₄F₈.

La figure 4B illustre la gravure isotrope du deuxième élément 21, à partir de la portion exposée 27 du deuxième élément 21. En plus de la portion exposée 27 du deuxième élément 21, une partie du deuxième élément 21 disposée entre la première couche isolante 13 et la deuxième couche isolante 23 et juxtaposée à la portion 27 est gravée, de façon à former une cavité 30 entre la première couche isolante 13 et la deuxième couche isolante 23. La profondeur de la cavité 30 est par exemple comprise entre environ 5 nm et 15 nm, et par exemple égale à environ 8 nm. La gravure isotrope correspond par exemple à une gravure humide de type TMAH sélective vis-à-vis du matériau diélectrique 73.

La figure 4C illustre la formation d'un espaceur 22 comportant un matériau diélectrique dans la cavité 30, entre le deuxième élément 21 et le contact en cours de formation. Pour cela, on procède au dépôt d'un matériau diélectrique puis à une gravure de ce matériau diélectrique comme cela a été décrit en relation avec les figures 1D et 1E.

La figure 4D illustre le prolongement de l'ouverture 25 et son remplissage par au moins un matériau conducteur 37. L'ouverture 25 est prolongée à travers le matériau diélectrique 73, jusqu'à atteindre le premier élément 11, par exemple par gravure en chimie fluorocarbonée. Le procédé de gravure est choisi de façon à graver de façon sélective le matériau diélectrique 73 par rapport au matériau diélectrique de l'espaceur 22. Avant la formation du matériau conducteur 37, il est possible de réaliser un nettoyage des fonds de contact. En outre, le masque dur est retiré.

Eventuellement, préalablement à la formation du matériau conducteur 37, une couche de barrière est formée au moins sur les parois de l'ouverture.

On a ainsi formé un contact 37 destiné à relier électriquement le premier élément 11 à un troisième élément d'un troisième niveau destiné à être formé sur le deuxième niveau comportant le deuxième élément 21. Le contact 37 est isolé électriquement du deuxième élément 21 du deuxième niveau par l'espaceur 22.

Une variante telle que celle décrite en relation avec les figures 4A-4D pourra être utilisée dans le cas de la variante des figures 2A-2D et dans le cas des exemples de réalisation des figures 3A-3D. Selon la variante des figures 4A-4D, l'ouverture auto-alignée sur le deuxième élément 21 est formée par gravure partielle du matériau diélectrique 73 et non pas par gravure avec arrêt sur la première couche isolante 13.

On a décrit ci-dessus différents exemples de réalisation et différentes variantes d'un procédé de formation d'un contact 3D auto-aligné. Comme cela a été décrit, lors de la formation de l'ouverture auto-alignée destinée à former le contact, l'ouverture est formée de façon à déboucher au moins en partie sur le deuxième élément 21 du deuxième niveau. Excepté dans le cas de l'exemple de réalisation des figures 3A-3D, l'ouverture peut déboucher en totalité sur le deuxième élément 21.

On a décrit ci-dessus différents exemples de réalisation et différentes variantes d'un procédé de formation d'un contact 3D auto-aligné permettant de relier électriquement des éléments de deux niveaux non adjacents séparés par un niveau intermédiaire unique. Bien entendu, les procédés décrits ci-dessus pourront être utilisés pour relier électriquement des éléments de deux niveaux non adjacents séparés par plusieurs niveaux intermédiaires.

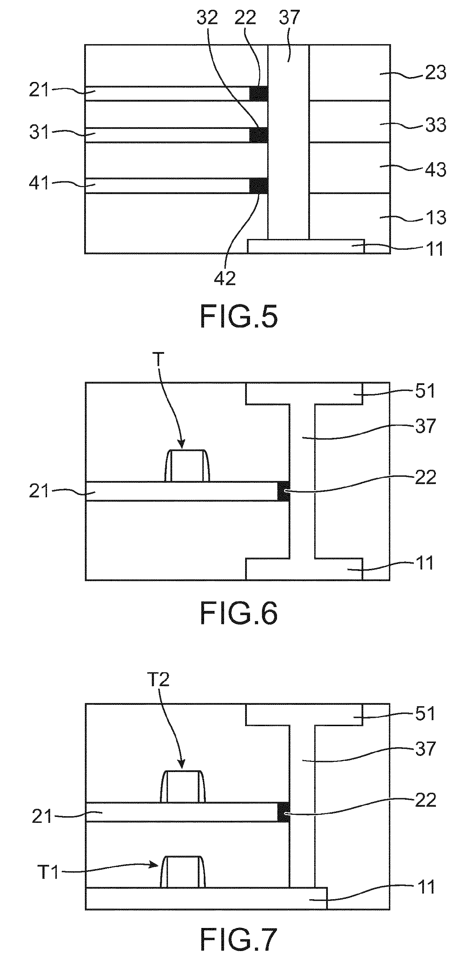

La figure 5 est une vue en coupe représentant de façon schématique un exemple de structure obtenue par un procédé du type de celui décrit en relation avec les figures 1A-1G.

La structure comprend un niveau inférieur comportant un élément inférieur 11 recouvert d'une couche isolante 13. La couche isolante 13 est recouverte de trois niveaux intermédiaires comportant chacun une zone d'accès 21, 31, 41 recouverte d'une couche isolante 23, 33, 43.

On a formé un contact 37 destiné à relier électriquement l'élément inférieur 11 à un élément d'un niveau supérieur destiné à être formé sur la couche isolante 23. Le contact 37 est isolé électriquement de chaque zone d'accès 21, 31, 41 des niveaux intermédiaires par un espaceur 22, 32, 42.

La figure 6 est une vue en coupe représentant de façon schématique un exemple de structure obtenue par un procédé du type de celui décrit en relation avec les figures 1A-1G, par exemple dans le cadre de l'intégration 3D monolithique.

Le premier élément 11 du premier niveau est formé d'une ligne métallique. Le deuxième élément 21 du deuxième niveau est formé d'une zone active d'un transistor T. Un contact 37 relie électriquement la ligne métallique 11 du premier niveau à une ligne métallique 51 d'un troisième niveau formé sur le deuxième niveau. Le contact 37 est isolé électriquement de la zone active 21 du deuxième niveau par un espaceur 22, ce qui permet notamment de ne pas détériorer les performances du transistor T.

Bien que la figure 6 corresponde au cas où le contact 37 traverse un seul niveau comportant une zone active de transistors, le contact 37 peut bien entendu traverser plusieurs niveaux comportant des zones actives de transistors.

Un procédé du type de ceux décrits ci-dessus permet de relier électriquement des lignes métalliques de niveaux non adjacents, le contact étant isolé électriquement des zones actives de dispositifs des niveaux intermédiaires traversés.

La figure 7 est une vue en coupe représentant de façon schématique un autre exemple de structure obtenue par un procédé du type de celui décrit en relation avec les figures 1A-1G, par exemple dans le cadre de l'intégration 3D monolithique.

Le premier élément 11 du premier niveau est formé d'une zone active d'un transistor T1. Le deuxième élément 21 du deuxième niveau est formé d'une zone active d'un transistor T2. Un contact 37 relie électriquement la zone active 11 du premier niveau à une ligne métallique 51 d'un troisième niveau formé sur le deuxième niveau. Le contact 37 est isolé électriquement de la zone active 21 du deuxième niveau par un espaceur 22, ce qui permet notamment de ne pas détériorer les performances du transistor T2.

Bien que la figure 7 corresponde au cas où le contact 37 traverse un seul niveau comportant une zone active de transistors, le contact 37 peut bien entendu traverser plusieurs niveaux comportant des zones actives de transistors.

Un procédé du type de ceux décrits ci-dessus permet de relier électriquement une ligne métallique d'un niveau supérieur et une zone active de dispositifs d'un niveau inférieur non adjacent, le contact étant isolé électriquement des zones actives de dispositifs des niveaux intermédiaires traversés.

Dans les différents exemples et variantes de réalisation décrits ci-dessus, le premier élément 11 peut être une zone active de dispositif ou une ligne conductrice d'un niveau intermédiaire. Le deuxième élément 21 peut être une zone d'accès à un dispositif, par exemple une zone active de dispositif ou une ligne conductrice d'un niveau intermédiaire.

A titre d'exemple de matériaux :
- le premier élément 11 comporte au moins un matériau semi-conducteur, par exemple un matériau semi-conducteur siliciuré, ou au moins un matériau conducteur, par exemple un matériau métallique ;
- le deuxième élément 21 comporte au moins un matériau semi-conducteur, par exemple un matériau semi-conducteur siliciuré, ou au moins un matériau conducteur, par exemple un matériau métallique. Le matériau semi-conducteur peut être polycristallin ou monocristallin ;
- le contact 37 comporte au moins un matériau conducteur, par exemple un matériau métallique ou un matériau semi-conducteur dopé, par exemple du silicium polycristallin ou du SiGe ; et
- l'espaceur 22,52 comporte au moins un matériau diélectrique, notamment choisi en fonction du couplage diélectrique que l'on veut assurer entre le contact et le deuxième élément.

## Revendications

1. Procédé de réalisation d'un circuit intégré, comprenant au moins les étapes suivantes :
a) formation d'un premier élément (11) semi-conducteur ou conducteur, recouvert d'une première couche isolante (13) sur laquelle est disposé un deuxième élément (21) semi-conducteur ou conducteur, recouvert d'une deuxième couche isolante (23) ;
b) formation d'une ouverture (25) traversant au moins la deuxième couche isolante (23), exposant une portion (27) du deuxième élément (21) et débouchant au moins en partie sur le deuxième élément (21) ou à côté du deuxième élément (21) ;
c) formation d'un espaceur (22, 52) localisé au niveau du deuxième élément (21) et comportant au moins un matériau diélectrique disposé au moins entre le deuxième élément (21) et l'ouverture (25) ;
d) prolongement de l'ouverture (25) à travers la première couche isolante (13) jusqu'à atteindre le premier élément (11) ;
e) remplissage de l'ouverture (25) par au moins un matériau conducteur (37), de façon à former un contact ;
et dans lequel l'étape c) de formation de l'espaceur (22) comporte au moins les étapes suivantes :
- gravure isotrope d'une partie du deuxième élément (21) incluant au moins ladite portion (27) du deuxième élément (21), de façon à former une cavité (30) disposée entre les première (13) et deuxième (23) couches isolantes ;
- dépôt d'au moins un matériau diélectrique (34) au moins sur les parois de l'ouverture (25) et dans la cavité (30) ; et
- élimination du matériau diélectrique (34) excepté dans la cavité (30).

2. Procédé selon la revendication 1, dans lequel, lors de l'étape b), l'ouverture (25) est formée jusqu'à atteindre la première couche isolante (13).

3. Procédé selon la revendication 1, dans lequel les première et deuxième couches isolantes (13, 23) sont de même nature et dans lequel, lors de l'étape b), l'ouverture (25) traverse en partie la première couche isolante (13).

4. Procédé selon l'une des revendications précédentes, dans lequel une dimension (r₂) de la cavité (30) sensiblement perpendiculaire à l'axe principal de l'ouverture (25) est telle qu'une partie (35) de la cavité (30) n'est pas remplie de matériau diélectrique (34) après le dépôt du matériau diélectrique (34).

5. Procédé selon l'une des revendications précédentes, dans lequel, lors de l'étape b), l'ouverture (25) est formée de façon à déboucher en partie seulement sur le deuxième élément (21).

6. Procédé selon l'une des revendications précédentes, dans lequel, lors de l'étape e) de remplissage de l'ouverture (25), une couche barrière électriquement conductrice est préalablement formée dans l'ouverture (25) avant la formation du matériau conducteur (37).

7. Procédé selon l'une des revendications précédentes, dans lequel le premier élément (11) est une zone active d'au moins un premier transistor (T1) ou une première ligne métallique, et/ou dans lequel le deuxième élément (21) est une zone active d'au moins un deuxième transistor (T, T2) ou une deuxième ligne métallique.

8. Procédé selon l'une des revendications précédentes, dans lequel, lors de l'étape a), au moins un élément intermédiaire (31, 41) semi-conducteur ou conducteur, recouvert d'une couche isolante intermédiaire (33, 43) est disposé entre la première couche isolante (13) et le deuxième élément (21), et comprenant en outre, entre les étapes c) et d), les étapes suivantes réalisées pour le ou chaque élément intermédiaire (31, 41) :
- prolongement de l'ouverture (25) à travers la couche isolante intermédiaire (33, 43) recouvrant ledit élément intermédiaire (31, 41), tel que l'ouverture (25) expose une portion dudit élément intermédiaire (31, 41) et débouche au moins en partie sur ledit élément intermédiaire (31, 41) ou à côté dudit élément intermédiaire (31, 41) ; et
- formation d'un espaceur intermédiaire (32, 42) localisé au niveau dudit élément intermédiaire (31, 41) et comportant au moins un matériau diélectrique disposé au moins entre ledit élément intermédiaire (31, 41) et l'ouverture (25).
